# EUROPEAN PATENT APPLICATION

(11) **EP 4 318 946 A1**
(43) Date of publication of application: **07.02.2024**
(21) Application number: 22790832.4
(22) Date of filing: 30.03.2022
(51) Int. Cl.: H03H 9/46, H03H 9/02, H01L 25/16

(54) **FILTER STRUCTURE AND ELECTRONIC DEVICE**

(30) Priority: 23.04.2021 CN 202110444520
(71) Applicant: Huawei Technologies Co., Ltd., Shenzhen, Guangdong 518129 (CN)
(72) Inventor: SUI, Kehan, Shenzhen, Guangdong 518129 (CN); BAI, Xinhao, Shenzhen, Guangdong 518129 (CN); ZHOU, Yan, Shenzhen, Guangdong 518129 (CN); CAI, Yuanbin, Shenzhen, Guangdong 518129 (CN)
(74) Representative: Huawei European IPR
(86) International application number: PCT/CN2022/084218
(87) International publication number: WO 2022/222723

(57) **Abstract**

Embodiments of this application provide a filtering structure and an electronic device. In the filtering structure, an intermediate assembly is disposed between a chip and a circuit board, a first filtering assembly is disposed inside the intermediate assembly, and at least a part of a second filtering assembly is disposed on a surface that is of the circuit board and that is away from the intermediate assembly, so that the first filtering assembly is close to the chip. This shortens a filtering path of the chip, improves a dynamic response capability of the chip, and therefore improves an overall filtering capability.

## Description

This application claims priority to Chinese Patent Application No. 202110444520.1, filed with the China National Intellectual Property Administration on April 23, 2021 and entitled "FILTERING STRUCTURE AND ELECTRONIC DEVICE", which is incorporated herein by reference in its entirety.

### TECHNICAL FIELD

Embodiments of this application relate to the field of filtering technologies, and in particular, to a filtering structure and an electronic device.

### BACKGROUND

As a switching capability and a computing capability of an integrated chip are continuously improved, a current and total power consumption of the chip are significantly increased. A rapid transient jump of a large current needs to be suppressed by a quick discharge of a filter capacitor in a power supply circuit to prevent a voltage drop. A capacity, a layout, equivalent series resistance (Equivalent Series Resistance, ESR) or equivalent series inductance (Equivalent Series Inductance, ESL), and the like of a capacitor in a power supply network have decisive impact on voltage drop and power supply quality in a system. Therefore, a high-current filtering solution becomes core competency of a product.

In a conventional technology, a filtering architecture generally includes a chip, a chip package structure, a circuit board, a voltage regulator module (Voltage Regulator Module, VRM), and a capacitor and an inductor thereof. A low-frequency capacitor with a large capacity is arranged on the periphery of the chip and in the vicinity of the VRM, and a high-frequency capacitor with a small capacity is arranged on a side that is of the circuit board and that is away from the chip, and is located in a projection region of the chip on the circuit board.

However, in the foregoing solution, a filtering path of the chip is long. As a result, a dynamic response capability of the chip is poor, and overall filtering performance needs to be improved.

### SUMMARY

Embodiments of this application provide a filtering structure and an electronic device, to shorten a filtering path of a chip and improve a dynamic response capability of the chip, and therefore improve an overall filtering capability.

According to a first aspect of embodiments of this application, a filtering structure is provided, including: a chip, a circuit board, a filtering assembly, and an intermediate assembly located between the chip and the circuit board. The filtering assembly includes a first filtering assembly and a second filtering assembly, the first filtering assembly is located in the intermediate assembly, and at least a part of the second filtering assembly is located on a surface that is of the circuit board and that is away from the intermediate assembly.

According to the filtering structure provided in this embodiment of this application, the intermediate assembly is disposed between the chip and the circuit board, the first filtering assembly is disposed inside the intermediate assembly, and at least a part of the second filtering assembly is disposed on the surface that is of the circuit board and that is away from the intermediate assembly. In a conventional technology, a low-frequency capacitor with a large capacity is disposed on the periphery of a chip and a high-frequency capacitor with a small capacity is disposed on a side that is of a circuit board and that is away from the chip. Compared to the conventional technology, in this embodiment, a distance between the first filtering assembly and the chip can be reduced. This shortens a filtering path of the chip, improves a dynamic response capability of the chip, and therefore improves an overall filtering capability.

In a possible implementation, the first filtering assembly includes a plurality of first filtering components, and the plurality of first filtering components are evenly spaced in the intermediate assembly. The plurality of first filtering components are evenly spaced in the intermediate assembly, so that filtering performance and evenness can be further enhanced while the filtering path of the chip is shortened.

In a possible implementation, the first filtering component is a capacitor.

In a possible implementation, the first filtering assembly includes a plurality of first filtering components and a plurality of second filtering components; and along a thickness direction of the circuit board, the plurality of first filtering components and the plurality of second filtering components form a plurality of isolators in a one-to-one correspondence; and the plurality of isolators are evenly spaced in the intermediate assembly. The plurality of first filtering components and the plurality of second filtering components form the plurality of isolators in a one-to-one correspondence, so that transfer impedance between different power supply domains of the chip can be reduced, thereby reducing noise, and improving isolation of the filtering structure.

In a possible implementation, the first filtering component is located on a side that is of the intermediate assembly and that is close to the chip, and the second filtering component is located on a side that is of the intermediate assembly and that is close to the circuit board. The first filtering component is disposed on the side that is of the intermediate assembly and that is close to the chip, and the second filtering component is disposed on the side that is of the intermediate assembly and that is close to the circuit board. This can ensure that the first filtering component is close to the chip, so that a distance between the first filtering component and the chip is small, and it is ensured that the filtering path of the chip can be shortened.

In a possible implementation, the first filtering component is a capacitor, and the second filtering component is an inductor or a bead.

In a possible implementation, the second filtering assembly includes at least one third filtering component, and the at least one third filtering component is located on a surface that is of the circuit board and that is away from the intermediate assembly.

In a possible implementation, the third filtering component is a capacitor.

In a possible implementation, the second filtering assembly includes at least one third filtering component and at least one fourth filtering component. The at least one third filtering component is located on a surface that is of the circuit board and that is away from the intermediate assembly. The at least one fourth filtering component is located on a side that is of the circuit board and that faces the intermediate assembly. The third filtering component is located in a projection region of the chip on the circuit board.

In a possible implementation, both the third filtering component and the fourth filtering component are capacitors.

In a possible implementation, a projection area of the first filtering component along the thickness direction of the circuit board is less than a projection area of the fourth filtering component along the thickness direction of the circuit board. Because a filtering component with a smaller size responds faster, it can be ensured that a distance between the first filtering component with a smaller size and the chip is small, and a shorter power supply path can be obtained while a filtering path of the chip is shortened.

In a possible implementation, a voltage regulator module is further included. The voltage regulator module is located on a surface that is of the circuit board and that faces the chip. The voltage regulator module is disposed adjacent to the fourth filtering component. The voltage regulator module is located outside the projection region of the chip on the circuit board. In this way, electrical energy from the voltage regulator module can enter the circuit board after being filtered by the fourth filtering component, to implement a process of supplying power to the chip.

In a possible implementation, the projection area of the first filtering component along the thickness direction of the circuit board is less than a projection area of the third filtering component along the thickness direction of the circuit board. Because a filtering component with a smaller size responds faster, it can be ensured that a distance between the first filtering component with a smaller size and the chip is small, and a shorter power supply path can be obtained while a filtering path of the chip is shortened.

In a possible implementation, the intermediate assembly includes at least two conductive layers disposed in a laminated manner, and a dielectric layer is disposed between two adjacent conductive layers. The first filtering assembly is located in the dielectric layer, and both ends of the first filtering assembly are electrically connected to the conductive layers located on two sides of the dielectric layer. In this way, the first filtering assembly is connected to the chip and the circuit board through the conductive layer, to ensure that a complete filtering path and a complete power supply path are formed.

In a possible implementation, the at least two conductive layers include a first conductive layer and a second conductive layer. A first dielectric layer is disposed between the first conductive layer and the second conductive layer. The first filtering assembly is located in the first dielectric layer. One of the first conductive layer and the second conductive layer is electrically connected to the chip, and the other of the first conductive layer and the second conductive layer is electrically connected to the circuit board. The first filtering assembly is connected to the chip and the circuit board through the first conductive layer and the second conductive layer respectively, to ensure that a complete filtering path and a complete power supply path are formed.

In a possible implementation, the first conductive layer has a plurality of first power supply contacts and a plurality of first ground contacts. The plurality of first power supply contacts and the plurality of first ground contacts are alternately spaced. The second conductive layer has a plurality of second power supply contacts and a plurality of second ground contacts. The second conductive layer is divided into a first region and a second region. The plurality of second power supply contacts are located in either the first region or the second region, and the plurality of second ground contacts are located in either the first region or the second region. The first power supply contacts are electrically connected to the second power supply contacts, and the first ground contacts are electrically connected to the second ground contacts. The first conductive layer is electrically connected to one of the chip and the circuit board through the plurality of first power supply contacts and the plurality of first ground contacts. The second conductive layer is electrically connected to the other of the chip and the circuit board through the plurality of second power supply contacts and the plurality of second ground contacts.

In this way, the second power supply contacts on the second conductive layer are all located in the first region, and the second ground contacts on the second conductive layer are all located in the second region. Because the second conductive layer is electrically connected to the circuit board, it can be ensured that the third filtering component with a larger size and a larger capacity or a larger quantity of filtering components (that is, a capacitor with a larger size and a larger capacity or a larger quantity of capacitors) is/are placed on the back of the circuit board. This improves a total capacity of the capacitor. In addition, if a size, capacity, and quantity of the third filtering component remain unchanged, a layout area on the circuit board can be saved to some extent compared with that in the conventional technology.

In a possible implementation, the first filtering assembly includes a first power terminal and a first ground terminal. A part of the first power terminal is electrically connected to both the first conductive layer and the second conductive layer, and a remaining part of the first power terminal is electrically connected to only the first conductive layer. A part of the first ground terminal is electrically connected to only the first conductive layer, and a remaining part of the first ground terminal is electrically connected to both the first conductive layer and the second conductive layer.

In a possible implementation, the first power terminal located in a projection region of the first region is electrically connected to both the first conductive layer and the second conductive layer, and the first ground terminal located in the projection region of the first region is electrically connected to only the first conductive layer; and the first power terminal located in a projection region of the second region is electrically connected only to the first conductive layer, and the first ground terminal located in the projection region of the second region is electrically connected to both the first conductive layer and the second conductive layer.

Alternatively, the first power terminal located in a projection region of the first region is electrically connected only to the first conductive layer, and the first ground terminal located in the projection region of the first region is electrically connected to both the first conductive layer and the second conductive layer; and the first power terminal located in a projection region of the second region is electrically connected to both the first conductive layer and the second conductive layer, and the first ground terminal located in the projection region of the second region is electrically connected to only the first conductive layer.

In this way, it can be ensured that a part of the first power terminal of the first filtering assembly located in the projection region of the first region is connected to the second power supply contact in the first region, and a part of the first ground terminal of the first filtering assembly located in the projection region of the second region is connected to the second ground contact in the first region. Alternatively, a part of the first ground terminal of the first filtering assembly located in the projection region of the first region is connected to the second ground contact in the first region, and a part of the first power terminal of the first filtering assembly located in the projection region of the second region is connected to the second power supply contact in the first region. In this way, a quantity of connection paths between the first filtering assembly and the second conductive layer is reduced. This simplifies a process and reduces costs to some extent.

In a possible implementation, the first power terminal located in the projection region of the first region is electrically connected to the first conductive layer through a first power supply conductive via, the first power terminal located in the projection region of the first region is electrically connected to the second conductive layer through a second power supply conductive via, and the first ground terminal located in the projection region of the first region is electrically connected to the first conductive layer through a first ground conductive via; and the first power terminal located in the projection region of the second region is electrically connected to the first conductive layer through the first power supply conductive via, the first ground terminal located in the projection region of the second region is electrically connected to the first conductive layer through the first ground conductive via, and the first ground terminal located in the projection region of the second region is electrically connected to the second conductive layer through the second ground conductive via.

Alternatively, the first power terminal located in the projection region of the first region is electrically connected to the first conductive layer through the first power supply conductive via, the first ground terminal located in the projection region of the first region is electrically connected to the first conductive layer through the first ground conductive via, and the first ground terminal located in the projection region of the first region is electrically connected to the second conductive layer through the second ground conductive via; and the first power terminal located in the projection region of the second region is electrically connected to the first conductive layer through the first power supply conductive via, the first power terminal located in the projection region of the second region is electrically connected to the second conductive layer through the second power supply conductive via, and the first ground terminal located in the projection region of the second region is electrically connected to the first conductive layer through the first ground conductive via.

In a possible implementation, the at least two conductive layers further include a third conductive layer and a fourth conductive layer. The third conductive layer and the fourth conductive layer are both located between the first dielectric layer and the second conductive layer. A second dielectric layer is disposed between the third conductive layer and the fourth conductive layer. The third conductive layer is located between the first dielectric layer and the second dielectric layer. A third dielectric layer is further disposed between the fourth conductive layer and the second conductive layer. One of the third conductive layer and the fourth conductive layer is a power supply layer, and the other of the third conductive layer and the fourth conductive layer is a ground layer.

In a possible implementation, the first filtering assembly includes a first power terminal and a first ground terminal. The first power terminal is electrically connected to the first conductive layer through a first power supply conductive via, and the first ground terminal is electrically connected to the first conductive layer through a first ground conductive via. A part of the first power terminal is electrically connected to the second conductive layer through a second power supply conductive via, a remaining part of the first power terminal is in contact with the third conductive layer, and the third conductive layer is electrically connected to the second conductive layer through a first conductive connection via. A part of the first ground terminal is electrically connected to the second conductive layer through a second ground conductive via, a remaining part of the first ground terminal is electrically connected to the fourth conductive layer through a third ground conductive via, and the fourth conductive layer is electrically connected to the second conductive layer through a second conductive connection via. The third conductive layer is the power supply layer, and the fourth conductive layer is the ground layer.

In a possible implementation, the first power terminal located in a projection region of the first region is electrically connected to the second conductive layer through the second power supply conductive via, the first ground terminal located in the projection region of the first region is electrically connected to the fourth conductive layer through the third ground conductive via, and the fourth conductive layer is electrically connected to the second conductive layer through the second conductive connection via; and the first power terminal located in a projection region of the second region is in contact with the third conductive layer, the third conductive layer is electrically connected to the second conductive layer through the first conductive connection via, and the first ground terminal located in the projection region of the second region is electrically connected to the second conductive layer through the second ground conductive via.

Alternatively, the first power terminal located in a projection region of the first region is in contact with the third conductive layer, the third conductive layer is electrically connected to the second conductive layer through the first conductive connection via, and the first ground terminal located in the projection region of the first region is electrically connected to the second conductive layer through the second ground conductive via; and the first power terminal located in a projection region of the second region is electrically connected to the second conductive layer through the second power supply conductive via, the first ground terminal located in the projection region of the second region is electrically connected to the fourth conductive layer through the third ground conductive via, and the fourth conductive layer is electrically connected to the second conductive layer through the second conductive connection via.

In this way, it can be ensured that each first power terminal of the first filtering assembly located in the projection region of the first region is connected to the second power supply contact in the first region, and each first ground terminal of the first filtering assembly located in the projection region of the second region is connected to the second ground contact in the first region. Alternatively, each first ground terminal of the first filtering assembly located in the projection region of the first region is connected to the second ground contact in the first region, and each first power terminal of the first filtering assembly located in the projection region of the second region is connected to the second power supply contact in the first region. In this way, an effect of current conduction between the first filtering assembly and the second conductive layer is enhanced. This enhances an effect of current conduction and filtering performance between the first filtering assembly and the circuit board.

In a possible implementation, the first filtering assembly includes a first power terminal and a first ground terminal. The first power terminal is electrically connected to the first conductive layer through a first power supply conductive via, and the first ground terminal is electrically connected to the first conductive layer through a first ground conductive via. A part of the first power terminal is electrically connected to the second conductive layer through a second power supply conductive via, a remaining part of the first power terminal is electrically connected to the fourth conductive layer through a third power supply conductive via, and the fourth conductive layer is electrically connected to the second conductive layer through a second conductive connection via. A part of the first ground terminal is electrically connected to the second conductive layer through a second ground conductive via, a remaining part of the first ground terminal is in contact with the third conductive layer, and the third conductive layer is electrically connected to the second conductive layer through a first conductive connection via. The third conductive layer is the ground layer, and the fourth conductive layer is the power layer.

In a possible implementation, the first power terminal located in a projection region the first region is electrically connected to the second conductive layer through the third power supply conductive via, the first ground terminal located in the projection region of the first region is in contact with the third conductive layer, and the third conductive layer is electrically connected to the second conductive layer through the first conductive connection via; and the first power terminal located in a projection region of the second region is electrically connected to the fourth conductive layer through the third power supply conductive via, the fourth conductive layer is electrically connected to the second conductive layer through the second conductive connection via, and the first ground terminal located in the projection region of the second region is electrically connected to the second conductive layer through the second ground conductive via.

Alternatively, the first power terminal located in a projection region of the first region is electrically connected to the fourth conductive layer through the third power supply conductive via, the fourth conductive layer is electrically connected to the second conductive layer through the second conductive connection via, and the first ground terminal located in the projection region of the first region is electrically connected to the second conductive layer through the second ground conductive via; and the first power terminal located in a projection region of the second region is electrically connected to the second conductive layer through the third power supply conductive via, the first ground terminal located in the projection region of the second region is in contact with the third conductive layer, and the third conductive layer is electrically connected to the second conductive layer through the first conductive connection via.

In a possible implementation, the apparatus further includes at least one fifth conductive layer, where the fifth conductive layer is located between the first conductive layer and the first dielectric layer.

According to a second aspect of embodiments of this application, an electronic device is provided, including a subrack and any one of the foregoing filtering structures. The filtering structure is disposed in the subrack.

The electronic device provided in this embodiment of this application includes at least a filtering structure. In the filtering structure, an intermediate assembly is disposed between a chip and a circuit board, a first filtering assembly is disposed inside the intermediate assembly, and at least a part of a second filtering assembly is disposed on a surface that is of the circuit board and that is away from the intermediate assembly. In a conventional technology, a low-frequency capacitor with a large capacity is disposed on the periphery of a chip and a high-frequency capacitor with a small capacity is disposed on a side that is of a circuit board and that is away from the chip. Compared to the conventional technology, in this embodiment, a distance between the first filtering assembly and the chip can be reduced. This shortens a filtering path of the chip, improves a dynamic response capability of the chip, and therefore improves an overall filtering capability of the electronic device.

### BRIEF DESCRIPTION OF DRAWINGS

FIG. 1 is a schematic diagram of a structure of a filtering structure according to an embodiment of this application;
FIG. 2 is a schematic diagram of a structure of a filtering structure according to an embodiment of this application;
FIG. 3 is a schematic diagram of a structure of a filtering structure according to an embodiment of this application;
FIG. 4 is a schematic diagram of an operating principle of a filtering structure according to an embodiment of this application;
FIG. 5 is a schematic diagram of a structure of a filtering structure according to an embodiment of this application;
FIG. 6 is a schematic diagram of a structure of first power supply contacts and first ground contacts on a first conductive layer and a structure of second power supply contacts and second ground contacts on a second conductive layer of an intermediate assembly of a filtering structure according to an embodiment of this application;
FIG. 7A is a schematic diagram of a structure of a first capacitor group and a second capacitor group on a circuit board of a filtering structure in a conventional technology;
FIG. 7B is a schematic diagram of a structure of a second filtering assembly (a third filtering component and a fourth filtering component) on a circuit board of a filtering structure according to an embodiment of this application;
FIG. 8 is a schematic diagram of a structure of a filtering structure according to an embodiment of this application;
FIG. 9 is a schematic diagram of a structure of a filtering structure according to an embodiment of this application;
FIG. 10 is a schematic diagram of a structure of first power supply contacts and first ground contacts on a first conductive layer and a structure of second power supply contacts and second ground contacts on a second conductive layer of an intermediate assembly of a filtering structure according to an embodiment of this application; and
FIG. 11 is a schematic diagram of a structure of a filtering structure according to an embodiment of this application.

### Reference numerals:

100: filtering structure; 10: chip; 101: chip body;
102: package substrate; 103: first solder joint; 20: circuit board;
201: second connecting via; 201a: second power supply connecting via; 201b: second ground connecting via;
202: projection region of the chip body; 203: a saved region; 301: first filtering assembly;
3011: first filtering component; 3012: second filtering component; 3013: isolator;
3014: first power terminal; 3015: first ground terminal; 302: second filtering assembly;
3021: third filtering component; 3022: fourth filtering component; 3023: second power terminal;
3024: second ground terminal; 40: intermediate assembly; 401: first conductive layer;
401a: first power supply conductive via; 401b: first ground conductive via; 4011: first power supply contact;
4012: first ground contact; 402: second conductive layer; 402a: second power supply conductive via;
402b: second ground conductive via; 4021: second power supply contact; 4022: second ground contact;
4023: first region; 4024: second region; 403: first dielectric layer;
404: third conductive layer; 405: second dielectric layer; 406: fourth conductive layer;
406a: third power supply conductive via; 406b: third ground conductive via; 407: third dielectric layer;
408: first connecting via; 408a: first power supply connecting via; 408b: first ground connecting via;
4091: first conductive connection via; 4092: second conductive connection via; 50: voltage regulator module;
60: heat dissipation apparatus; 601: heat sink; 602: heat dissipation fin;
70: second solder joint; 80: third solder joint; 901: first capacitor group; and
902: second capacitor group.

### DESCRIPTION OF EMBODIMENTS

Terms used in implementations of this application are merely used to explain specific embodiments of this application, but are not intended to limit this application. The following describes implementations of embodiments of this application in detail with reference to the accompanying drawings.

There are thousands of transistors inside a chip. These transistors form an internal gate circuit, combinational logic, a register, a counter, a delay line, a state machine, and another logic function. As integration of the chip becomes higher, a quantity of internal transistors becomes larger. Because a quantity of external pins of the chip is limited, it is unrealistic to provide a separate power supply pin for each transistor. Therefore, the external power supply pin of the chip provides a common power supply node for the internal transistors. However, a state transition of the internal transistor inevitably causes transfer of power supply noise inside the chip. In addition to affecting an operating status of the chip, the power supply noise also has impact in other aspects. For example, power supply noise affects jitter features of a crystal oscillator, a phase-locked loop (Phase-Locked Loop, PLL), and a delay phase-locked loop (Delay-locked Loop, DLL), and conversion precision of an AD conversion circuit (which converts an analog signal into a digital signal). Most chips present a normal voltage fluctuation range, usually 3% to ±5%, which is noise margin of a power supply system. For a power supply scenario with a low voltage and a high current, an absolute value of the noise margin is reduced, which poses a great challenge to design of an entire power supply system.

Currently, a power distribution network (PDN) includes all interconnections from a voltage regulator module (VRM) to a pad of the chip, and then to an on-chip metal layer in a die that distributes a local voltage and a return current. A purpose of designing PDN interconnection is to ensure that impedance is lower than a target impedance value in a range from a direct current to a high frequency, so as to keep a chip voltage stable, minimize a ground spring, and minimize electromagnetic interference. For an entire PDN system, main decisive factors of the impedance are different at different frequencies.

Impedance of a low frequency kHz is determined by a large-capacity and large-size energy storage capacitor. The capacitor is typically an aluminum capacitor or on-chip multi-layer ceramic capacitor (Multi-layer Ceramic Capacitors, MLCC) packaged with 0805 size or above. The capacitor is mainly used to filter low-frequency noise and store energy. The capacitor is generally placed on a side of a circuit board (Printed Circuit Board, PCB) and occupies 70% to 80% of a filtering area. Impedance of MHz is determined by a decoupled capacitor. This type of capacitor includes an MLCC capacitor packaged with 0402 size or below. The capacitor is placed in a ball array package (Ball Grid Array, BGA) region on the back of the PCB under a projection plane, of a power supply, on a die. Capacitance of the capacitor is generally small (for example, less than 4.7 µF) and is used to filter high-frequency noise for the chip. Therefore, in a conventional filtering solution in a current application scenario, components in the entire power supply system occupy an increasingly large area of the entire circuit board, a filtering path is long, and serious loss occurs especially for a high current, and efficiency is low.

As a switching capability and a computing capability of an integrated chip are continuously improved, a current and total power consumption of the chip are significantly increased. A stable current of a power supply is 1000 A, and a transient jump is 2000 A/µs. A rapid transient jump of a large current needs to be suppressed by a quick discharge of a filter capacitor in a power supply circuit to prevent a voltage drop. A capacity, a layout, ESR or ESL, and the like of a capacitor in a power supply network have decisive impact on voltage drop and power supply quality in a system. Therefore, a high-current filtering solution becomes core competency of a product.

A filtering architecture in a conventional technology generally uses a horizontal filtering technology. A horizontal filtering architecture generally includes a chip, a chip package structure, a circuit board, a voltage regulator module (Voltage Regulator Module, VRM), and a capacitor and an inductor thereof. A low-frequency capacitor with a large capacity is arranged on the periphery of the chip and in the vicinity of the VRM, and a high-frequency capacitor with a small capacity is arranged on a side that is of the circuit board and that is away from the chip, and is located in a projection region of a die on the circuit board.

However, in the foregoing solution, a filtering path of the chip is long, resulting in a large filtering loss and poor overall filtering performance. In addition, capacitors of the chip occupy a large layout area on the periphery of the chip, which results in limited layout space. As a result, a quantity of capacitors placed on the back of the circuit board is limited, which further affects filtering performance.

Based on this, embodiments of this application provide a filtering structure. In the filtering structure, an intermediate assembly is disposed between a chip and a circuit board, a first filtering assembly is disposed inside the intermediate assembly, and at least a part of a second filtering assembly is disposed on a surface that is of the circuit board and that is away from the intermediate assembly. This shortens a filtering path of the chip, reduces direct current impedance on the filtering path. Therefore, a filtering loss is reduced, and an overall filtering capability is improved.

The following describes a specific structure of the filtering structure by using different embodiments as examples and with reference to the accompanying drawings.

### Embodiment 1

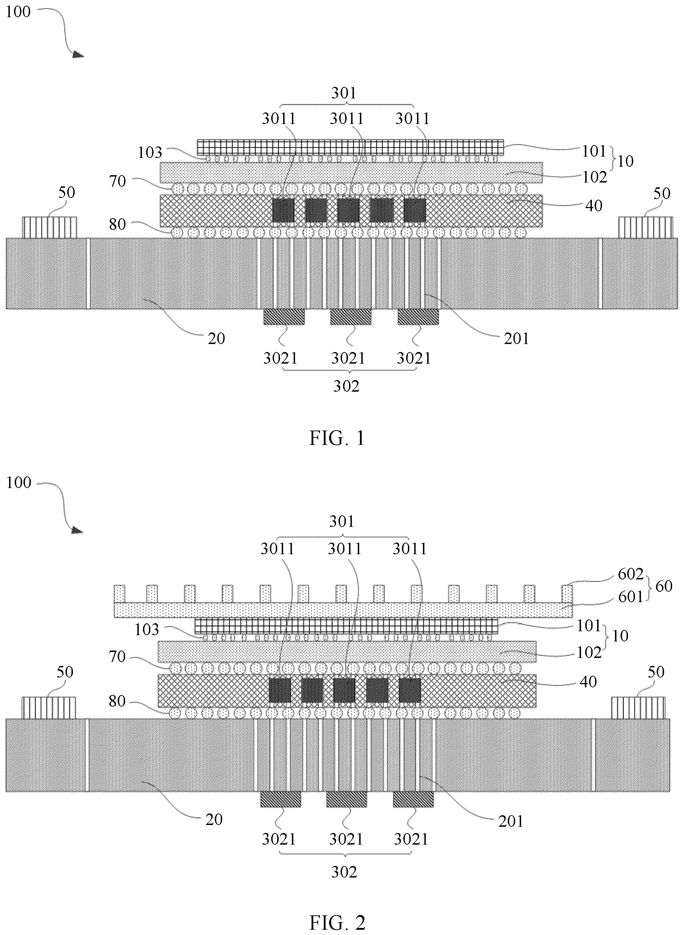

Refer to FIG. 1. An embodiment of this application provides a filtering structure 100. The filtering structure 100 may include a chip 10, a circuit board 20, a filtering assembly, and an intermediate assembly 40 located between the chip 10 and the circuit board 20. The filtering assembly may include a first filtering assembly 301 and a second filtering assembly 302. The first filtering assembly 301 is located in the intermediate assembly 40, and at least a part of the second filtering assembly 302 is located on a surface that is of the circuit board 20 and that is away from the intermediate assembly 40. Because the first filtering assembly 301 and the second filtering assembly 302 are close to the chip 10, a faster filtering response can be implemented.

Specifically, the chip 10 may include a chip body 101 and a package substrate 102 electrically connected to the chip 10. The package substrate 102 is located between the chip body 101 and the intermediate assembly 40, and the package substrate 102 is electrically connected to the intermediate assembly 40.

It is easy to understand that the chip body 101 may be electrically connected to the package substrate 102 through a plurality of first solder joints 103, the package substrate 102 may be electrically connected to the intermediate assembly 40 through a plurality of second solder joints 70, and the intermediate assembly 40 may be electrically connected to the circuit board 20 through a plurality of third solder joints 80.

The first filtering assembly 301 may include a plurality of first filtering components 3011, and the plurality of first filtering components 3011 are evenly spaced in the intermediate assembly 40. The plurality of first filtering components 3011 are evenly spaced in the intermediate assembly 40, so that filtering performance and evenness can be further enhanced while a filtering path of the chip 10 is shortened.

It is easy to understand that the intermediate assembly 40 may further be provided with a plurality of first connecting vias 408. The first connecting vias 408 may be deep microvias or filled through electroplating. The first connecting vias 408 may include a first power supply connecting via 408a and a first ground connecting via 408b. The first power supply connecting via 408a is configured to conduct a power signal, and the first ground connecting via 408b is configured to conduct a ground signal. Each first filtering component 3011 implements conduction of the power signal and the ground signal with the external through the first power supply connecting via 408a and the first ground connecting via 408b.

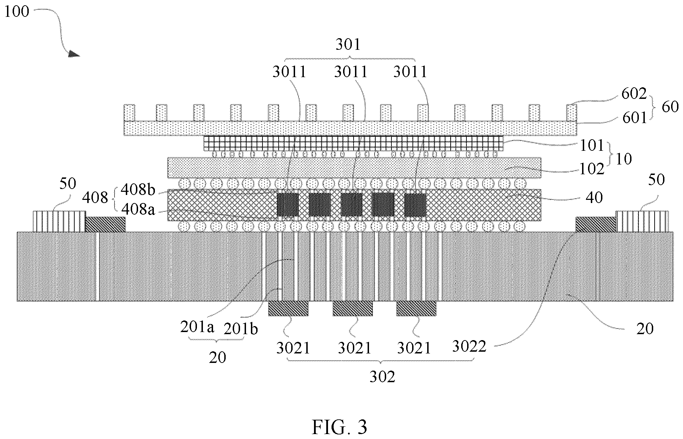

It should be noted that a projection area, along a thickness direction of the circuit board 20, of the first filtering assembly 301 located in the intermediate assembly 40 is greater than or equal to a distance between the first power supply connecting via 408a and the first ground connecting via 408b. Specifically, a size of the first filtering assembly 301 in a horizontal direction in FIG. 3 is greater than or equal to the distance between the first power supply connecting via 408a and the first ground connecting via 408b, to ensure conduction of the power signal and the ground signal of the first filtering assembly 301. For example, in FIG. 3, a size of the first filtering component 3011 in the horizontal direction is greater than the distance between the first power supply connecting via 408a and the first ground connecting via 408b.

In this embodiment of this application, the first filtering component 3011 may be a capacitor. Capacitance, also referred to as capacitance, is a quantity of charges stored under a given potential difference. Generally, charges move under a force in an electric field. When there is a medium between conductors, the charges are hindered from moving and accumulated on the conductors. As a result, the charges are accumulated and stored. A quantity of stored charges is referred to as capacitance.

In addition, in this embodiment of this application, a manner of disposing the second filtering assembly 302 may include but is not limited to the following two possible implementations:

In a possible implementation, as shown in FIG. 2, the second filtering assembly 302 may include at least one third filtering component 3021, and the at least one third filtering component 3021 is located on the surface that is of the circuit board 20 and that is away from the intermediate assembly 40. The third filtering component 3021 may be the capacitor.

In another possible implementation, as shown in FIG. 3, the second filtering assembly 302 may include at least one third filtering component 3021 and at least one fourth filtering component 3022. The at least one third filtering component 3021 is located on the surface that is of the circuit board 20 and that is away from the intermediate assembly 40. The at least one fourth filtering component 3022 is located on a surface that is of the circuit board 20 and that faces the intermediate assembly 40. The third filtering component 3021 is located in a projection region of the chip 10 on the circuit board 20. Both the third filtering component 3021 and the fourth filtering component 3022 may be capacitors.

It should be noted that, in this embodiment of this application, a projection area of the first filtering component 3011 along the thickness direction of the circuit board 20 may be less than a projection area of the fourth filtering component 3022 along the thickness direction of the circuit board 20. Because a filtering component with a smaller size responds faster, it can be ensured that a distance between the first filtering component 3011 with a smaller size and the chip 10 is small, and a shorter power supply path can be obtained while a filtering path of the chip 10 is shortened.

Still refer to FIG. 3. The filtering structure 100 provided in this embodiment of this application may further include a voltage regulator module 50. The voltage regulator module 50 is located on a surface that is of the circuit board 20 and that faces the chip 10. The voltage regulator module 50 is disposed adjacent to the fourth filtering component 3022. The voltage regulator module 50 is located outside the projection region of the chip 10 on the circuit board 20. In this way, electrical energy from the voltage regulator module 50 can enter the circuit board 20 after being filtered by the fourth filtering component 3022, to implement a process of supplying power to the chip 10.

It should be noted that, the projection area of the first filtering component 3011 along the thickness direction of the circuit board 20 may be less than a projection area of the third filtering component 3021 along the thickness direction of the circuit board 20. Because a filtering component with a smaller size responds faster, it can be ensured that a distance between the first filtering component 3011 with a smaller size and the chip 10 is small, and a shorter power supply path can be obtained while the filtering path of the chip 10 is shortened.

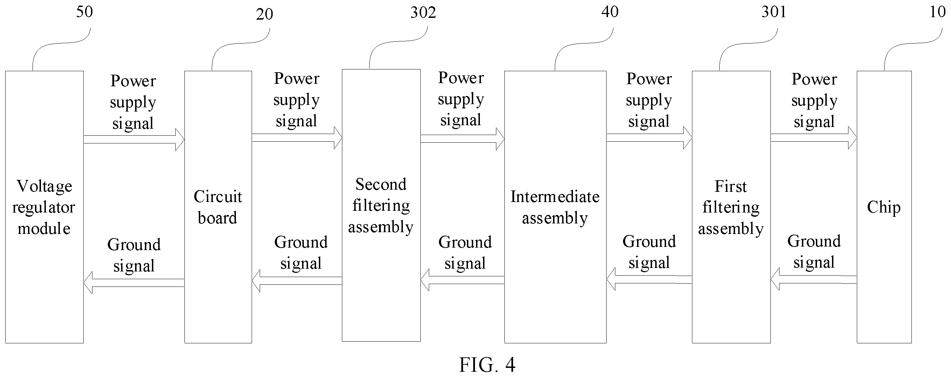

In actual application, as shown in FIG. 4, the power supply signal and the ground signal may form a signal transmission loop between the voltage regulator module 50, the circuit board 20, the intermediate assembly 40, the filtering assembly (the first filtering assembly 301 and the second filtering assembly 302), and the chip 10, to implement functions of power supply and filtering for the chip 10.

Based on the foregoing embodiment, the intermediate assembly 40 may include at least two conductive layers disposed in a laminated manner, and a dielectric layer is disposed between two adjacent conductive layers. The first filtering assembly 301 is located in the dielectric layer, and both ends of the first filtering assembly 301 are electrically connected to the conductive layers located on two sides of the dielectric layer. In this way, the first filtering assembly 301 is connected to the chip 10 and the circuit board 20 through the conductive layer, to ensure that a complete filtering path and a complete power supply path are formed.

It may be understood that the first filtering assembly 301 may be located between any two conductive layers in the intermediate assembly 40. In other words, the first filtering assembly 301 may be located on any dielectric layer in the intermediate assembly 40. A specific disposition location of the first filtering assembly 301 is not limited in this embodiment of this application. In addition, a dielectric thickness of the any dielectric layer may also be adjusted based on a specific thickness of the first filtering assembly 301.

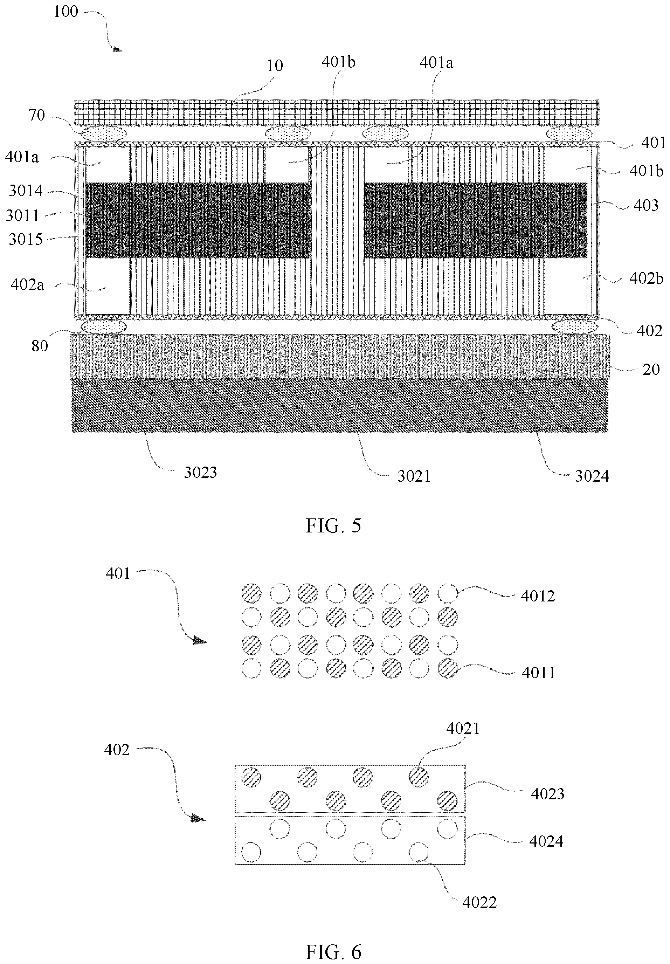

In some embodiments, with reference to FIG. 5, the at least two conductive layers may include a first conductive layer 401 and a second conductive layer 402. A first dielectric layer 403 is disposed between the first conductive layer 401 and the second conductive layer 402. The first filtering assembly 301 is located in the first dielectric layer 403. In addition, one of the first conductive layer 401 and the second conductive layer 402 is electrically connected to the chip 10, and the other of the first conductive layer 401 and the second conductive layer 402 is electrically connected to the circuit board 20. For example, in FIG. 5, the first conductive layer 401 is electrically connected to the chip 10, and the second conductive layer 402 is electrically connected to the circuit board 20. The first filtering assembly 301 is connected to the chip 10 and the circuit board 20 through the first conductive layer 401 and the second conductive layer 402 respectively, to ensure that a complete filtering path and a complete power supply path are formed.

It is easy to understand that the first conductive layer 401 and the second conductive layer 402 may be a power layer or a ground layer, to ensure that a decoupled loop in which the first filtering component 3011 (a high-frequency small capacitor) is embedded is complete.

In this embodiment of this application, with reference to FIG. 6, the first conductive layer 401 may have a plurality of first power supply contacts 4011 and a plurality of first ground contacts 4012. The plurality of first power supply contacts 4011 and the plurality of first ground contacts 4012 are alternately spaced. The second conductive layer 402 may include a plurality of second power supply contacts 4021 and a plurality of second ground contacts 4022. The second conductive layer 402 is divided into a first region 4023 and a second region 4024. The plurality of second power supply contacts 4021 are located in one of the first region 4023 or the second region 4024, and the plurality of second ground contacts 4022 are located in the other of the first region 4023 or the second region 4024. For example, in FIG. 6, the plurality of second power supply contacts 4021 are located in the first region 4023, and the plurality of second ground contacts 4022 are located in the second region 4024.

In this embodiment of this application, the first power supply contacts 4011 are electrically connected to the second power supply contacts 4021, and the first ground contacts 4012 are electrically connected to the second ground contacts 4022. In addition, the first conductive layer 401 is electrically connected to one of the chip 10 and the circuit board 20 through the plurality of first power supply contacts 4011 and the plurality of first ground contacts 4012. The second conductive layer 402 is electrically connected to the other of the chip 10 and the circuit board 20 through the plurality of second power supply contacts 4021 and the plurality of second ground contacts 4022. For example, in this embodiment of this application, the first conductive layer 401 may be electrically connected to the chip 10 through the plurality of first power supply contacts 4011 and the plurality of first ground contacts 4012, and the second conductive layer 402 may be electrically connected to the circuit board 20 through the plurality of second power supply contacts 4021 and the plurality of second ground contacts 4022.

In this way, it can be ensured that the third filtering component 3021 with a larger size and a larger capacity or a larger quantity of filtering components 3021 (that is, a capacitor with a larger size and a larger capacity or a larger quantity of capacitors) is/are placed on the back of the circuit board 20. This improves a total capacity of the capacitor. In addition, if a size, capacity, and quantity of the third filtering component 3021 remain unchanged, a layout area on the circuit board 20 can be saved to some extent compared with that in a conventional technology.

For example, the first filtering component 30 includes only the first filtering assembly 301. Still refer to FIG. 5. The first filtering assembly 301 may include a first power terminal 3014 and a first ground terminal 3015. A part of the first power terminal 3014 is electrically connected to the first conductive layer 401 and the second conductive layer 402, and a remaining part of the first power terminal 3014 is electrically connected to only the first conductive layer 401. A part of the first ground terminal 3015 is electrically connected only to the first conductive layer 401, and a remaining part of the first ground terminal 3015 is electrically connected to the first conductive layer 401 and the second conductive layer 402.

In an optional implementation, the first power terminal 3014 may be connected to the first power supply connecting via 408a, and the first ground terminal 3015 may be connected to the first ground connecting via 408b.

It is easy to understand that, the third filtering component 3021 may have a second power terminal 3023 and a second ground terminal 3024. The second power terminal 3023 of the third filtering component 3021 corresponds to the first region 4023 on the second conductive layer 402, and the second ground terminal 3024 of the third filtering component 3021 corresponds to the second region 4024 on the second conductive layer 402. In an optional implementation, a second connecting via 201 may further be provided in the circuit board 20. The second connecting via 201 may include a second power supply connecting via 201a and a second ground connecting via 201b. The second power supply connecting via 201a is configured to conduct a power signal, and the second ground connecting via 201b is configured to conduct a ground signal.

In some embodiments, the second power supply connecting via 201a may be connected to the second power terminal 3023 of the third filtering component 3021, and the second ground connecting via 201b may be connected to the second ground terminal 3024 of the third filtering component 3021.

It should be noted that in this embodiment of this application, a connection relationship between the first filtering assembly 301 and the conductive layer includes but is not limited to the following two possible implementations:

In a possible implementation, the first power terminal 3014 of the first filtering assembly 301 located in a projection region of the first region 4023 is electrically connected to the first conductive layer 401 and the second conductive layer 402, and the first ground terminal 3015 of the first filtering assembly 301 located in the projection region of the first region 4023 is electrically connected to only the first conductive layer 401. The first power terminal 3014 of the first filtering assembly 301 located in a projection region of the second region 4024 is electrically connected only to the first conductive layer 401, and the first ground terminal 3015 of the first filtering assembly 301 located in the projection region of the second region 4024 is electrically connected to the first conductive layer 401 and the second conductive layer 402.

Specifically, refer to FIG. 5. The first power terminal 3014 located in the projection region of the first region 4023 is electrically connected to the first conductive layer 401 through the first power supply conductive via 401a, the first power terminal 3014 located in the projection region of the first region 4023 is electrically connected to the second conductive layer 402 through the second power supply conductive via 402a, and the first ground terminal 3015 located in the projection region of the first region 4023 is electrically connected to the first conductive layer 401 through the first ground conductive via 401b. The first power terminal 3014 located in the projection region of the second region 4024 is electrically connected to the first conductive layer 401 through the first power supply conductive via 401a, the first ground terminal 3015 located in the projection region of the second region 4024 is electrically connected to the first conductive layer 401 through the first ground conductive via 401b, and the first ground terminal 3015 located in the projection region of the second region 4024 is electrically connected to the second conductive layer 402 through the second ground conductive via 402b.

In this way, it can be ensured that a part of the first power terminal 3014 of the first filtering assembly 301 located in the projection region of the first region 4023 is connected to the second power supply contact 4021 in the first region 4023, and a part of the first ground terminal 3015 of the first filtering assembly 301 located in the projection region of the second region 4024 is connected to the second ground contact 4022 in the first region 4023.

In another possible implementation, the first power terminal 3014 of the first filtering assembly 301 located in the projection region of the first region 4023 is electrically connected to only the first conductive layer 401, and the first ground terminal 3015 of the first filtering assembly 301 located in the projection region of the first region 4023 is electrically connected to the first conductive layer 401 and the second conductive layer 402. The first power terminal 3014 of the first filtering assembly 301 located in the projection region of the second region 4024 is electrically connected to the first conductive layer 401 and the second conductive layer 402, and the first ground terminal 3015 of the first filtering assembly 301 located in the projection region of the second region 4024 is electrically connected to only the first conductive layer 401.

Specifically, the first power terminal 3014 located in the projection region of the first region 4023 is electrically connected to the first conductive layer 401 through the first power supply conductive via 401a, the first ground terminal 3015 located in the projection region of the first region 4023 is electrically connected to the first conductive layer 401 through the first ground conductive via 401b, and the first ground terminal 3015 located in the projection region of the first region 4023 is electrically connected to the second conductive layer 402 through the second ground conductive via 402b. The first power terminal 3014 located in the projection region of the second region 4024 is electrically connected to the first conductive layer 401 through the first power supply conductive via 401a, the first power terminal 3014 located in the projection region of the second region 4024 is electrically connected to the second conductive layer 402 through the second power supply conductive via 402a, and the first ground terminal 3015 located in the projection region of the second region 4024 is electrically connected to the first conductive layer 401 through the first ground conductive via 401b.

In this way, it can be ensured that a part of the first ground terminal 3015 of the first filtering assembly 301 located in the projection region of the first region 4023 is connected to the second ground contact 4022 in the first region 4023, and a part of the first power terminal 3014 of the first filtering assembly 301 located in the projection region of the second region 4024 is connected to the second power supply contact 4021 in the first region 4023.

In this way, a quantity of connection paths between the first filtering assembly 301 and the third conductive layer 404 is reduced. This simplifies a process and reduces costs to some extent.

It may be understood that, in this embodiment of this application, as shown in FIG. 6, a quantity of second power supply contacts 4021 disposed may be less than a quantity of first power supply contacts 4011 disposed, and a quantity of second ground contacts 4022 disposed is less than a quantity of first ground contacts 4012 disposed.

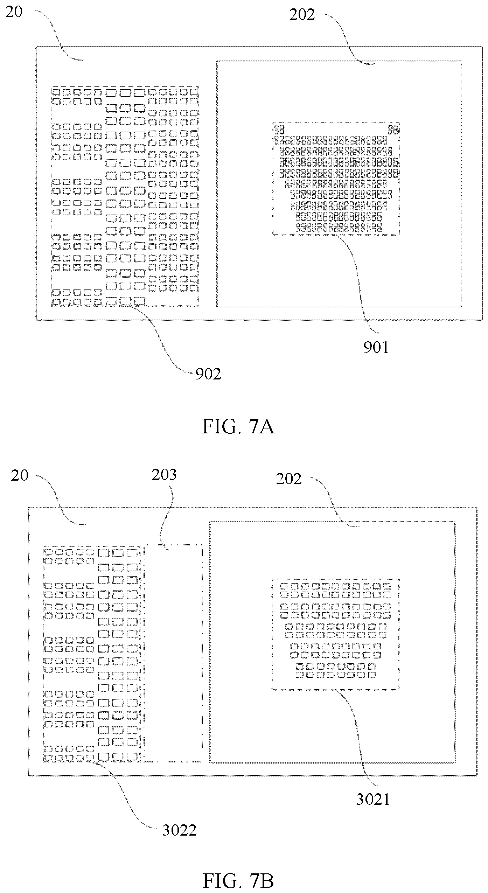

It may be understood that, with reference to FIG. 7A, a first capacitor group 901 (a plurality of small capacitors) and a second capacitor group 902 (a plurality of large capacitors) are generally disposed on the circuit board 20 in the conventional technology. The first capacitor group 901 is located in a projection region (that is, in a projection region 202 of the chip body in FIG. 7A) of the chip body 101 on the circuit board 20.

In some embodiments, the first capacitor group 901 is equivalent to the first filtering component 3011 in this embodiment of this application, and the second capacitor group 902 is equivalent to the third filtering component 3021 or the fourth filtering component 3022 in this embodiment of this application. In this embodiment of this application, the first filtering component 3011 is disposed inside the intermediate assembly 40, so that the third filtering component 3021 can be disposed in the projection region 202 of the chip body (referring to FIG. 7B). In other words, a part of the second capacitor group 902 on the circuit board 20 can be transferred to a position in which the first capacitor group 901 is disposed in the conventional technology. In this way, a region (namely, a saved region 203) in which a part of the second capacitor group 902 is originally disposed on the circuit board 20 can be saved, and a layout area on the circuit board 20 can be saved to some extent compared with that in the conventional technology.

In addition, the second power supply contacts 4021 on the second conductive layer 402 are integrated in the first region 4023, and the second ground contacts 4022 on the second conductive layer 402 are integrated in the second region 4024. In this way, it can be ensured that the third filtering component 3021 with a larger size and a larger capacity or a larger quantity of filtering components 3021 (that is, a capacitor with a larger size and a larger capacity or a larger quantity of capacitors) is/are placed on the back of the circuit board 20. This improves a total capacity of the capacitor. In addition, if the size, capacity, and quantity of the third filtering component 3021 remain unchanged, the layout area on the circuit board 20 can be further saved compared with that in the conventional technology.

In addition, with reference to FIG. 1 or FIG. 2, the filtering structure 100 provided in this embodiment of this application may further include a heat dissipation apparatus 60. The heat dissipation apparatus 60 is located on a side that is of the chip 10 and that is away from the intermediate assembly 40. Specifically, the heat dissipation apparatus 60 may include a heat sink 601 and heat dissipation fins 602 disposed on the heat sink 601. The heat dissipation apparatus 60 can dissipate heat for the chip 10, to reduce a temperature around the chip 10, and therefore prevent a short circuit or burning of the chip 10 caused by an excessively high temperature of the chip 10.

### Embodiment 2

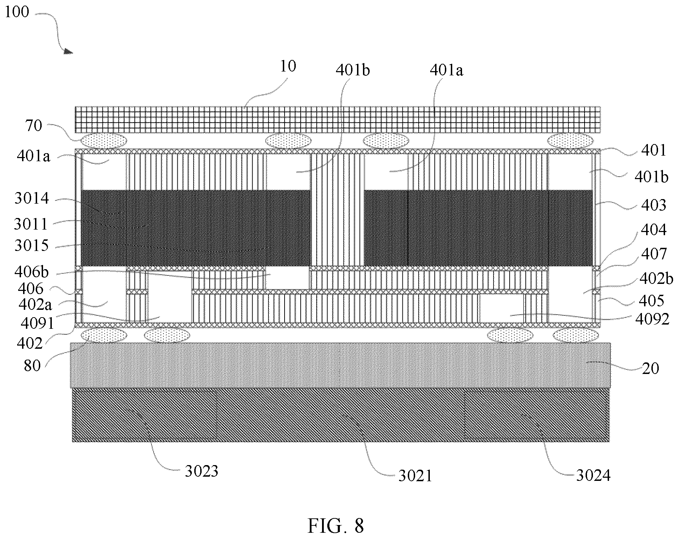

Different from Embodiment 1, with reference to FIG. 8, in this embodiment of this application, at least two conductive layers may further include a third conductive layer 404 and a fourth conductive layer 406. Both the third conductive layer 404 and the fourth conductive layer 406 are located between a first dielectric layer 403 and a second conductive layer 402. A second dielectric layer 405 is disposed between the third conductive layer 404 and the fourth conductive layer 406. The third conductive layer 404 is located between the first dielectric layer 403 and the second dielectric layer 405, and a third dielectric layer 407 is further disposed between the fourth conductive layer 406 and the second conductive layer 402. One of the third conductive layer 404 and the fourth conductive layer 406 is a power supply layer, and the other of the third conductive layer 404 and the fourth conductive layer 406 is a ground layer.

In some embodiments, as shown in FIG. 8, a first filtering assembly 301 may include a first power terminal 3014 and a first ground terminal 3015. The first power terminal 3014 is electrically connected to a first conductive layer 401 through a first power supply conductive via 401a, and the first ground terminal 3015 is electrically connected to the first conductive layer 401 through a first ground conductive via 401b. A part of the first power terminal 3014 is electrically connected to the second conductive layer 402 through a second power supply conductive via 402a. A remaining part of the first power terminal 3014 is in contact with the third conductive layer 404. The third conductive layer 404 is electrically connected to the second conductive layer 402 through a first conductive connection via 4091. A part of the first ground terminal 3015 is electrically connected to the second conductive layer 402 through a second ground conductive via 402b. A remaining part of the first ground terminal 3015 is electrically connected to the fourth conductive layer 406 through a third ground conductive via 406b. The fourth conductive layer 406 is electrically connected to the second conductive layer 402 through a second conductive connection via 4092. The third conductive layer 404 is the power supply layer, and the fourth conductive layer 406 is the ground layer. In this way, smoothness of a filtering path and a power supply path can be ensured.

It should be noted that in this embodiment of this application, a connection relationship between the first filtering assembly 301 and the conductive layer includes but is not limited to the following two possible implementations:

In a possible implementation, with reference to FIG. 8, the first power terminal 3014 of the first filtering assembly 301 located in a projection region of a first region 4023 is electrically connected to the second conductive layer 402 through the second power supply conductive via 402a. The first ground terminal 3015 of the first filtering assembly 301 located in the projection region of the first region 4023 is electrically connected to the fourth conductive layer 406 through the third ground conductive via 406b. The fourth conductive layer 406 is electrically connected to the second conductive layer 402 through the second conductive connection via 4092. The first power terminal 3014 of the first filtering assembly 301 located in a projection region of the second region 4024 is in contact with the third conductive layer 404. The third conductive layer 404 is electrically connected to the second conductive layer 402 through the first conductive connection via 4091. The first ground terminal 3015 of the first filtering assembly 301 located in the projection region of the second region 4024 is electrically connected to the second conductive layer 402 through the second ground conductive via 402b.

In this way, it can be ensured that the first power terminal 3014 of the first filtering assembly 301 located in the projection region of the first region 4023 is connected to a second power supply contact 4021 in the first region 4023, and the first ground terminal 3015 of the first filtering assembly 301 located in the projection region of the second region 4024 is connected to a second ground contact 4022 in the first region 4023.

In another possible implementation, the first power terminal 3014 of the first filtering assembly 301 located in the projection region of the first region 4023 is in contact with the third conductive layer 404. The third conductive layer 404 is electrically connected to the second conductive layer 402 through the first conductive connection via 4091. The first ground terminal 3015 of the first filtering assembly 301 located in the projection region of the first region 4023 is electrically connected to the second conductive layer 402 through the second ground conductive via 402b. The first power terminal 3014 of the first filtering assembly 301 located in the projection region of the second region 4024 is electrically connected to the second conductive layer 402 through the second power supply conductive via 402a. The first ground terminal 3015 of the first filtering assembly 301 located in the projection region of the second region 4024 is electrically connected to the fourth conductive layer 406 through the third ground conductive via 406b. The fourth conductive layer 406 is electrically connected to the second conductive layer 402 through the second conductive connection via 4092.

In this way, it can be ensured that the first ground terminal 3015 of the first filtering assembly 301 located in the projection region of the first region 4023 is connected to the second ground contact 4022 in the first region 4023, and the first power terminal 3014 of the first filtering assembly 301 located in the projection region of the second region 4024 is connected to the second power supply contact 4021 in the first region 4023.

In this way, an effect of current conduction between the first filtering assembly 301 and the fourth conductive layer 406 is enhanced. This enhances an effect of current conduction and filtering performance between the first filtering assembly 301 and the circuit board 20.

Further, as shown in FIG. 8, more second conductive connection vias 4092 may be disposed in the second dielectric layer 405 (that is, between the second conductive layer 402 and the fourth conductive layer 406), to increase a current conduction capability between layers of the intermediate assembly 40.

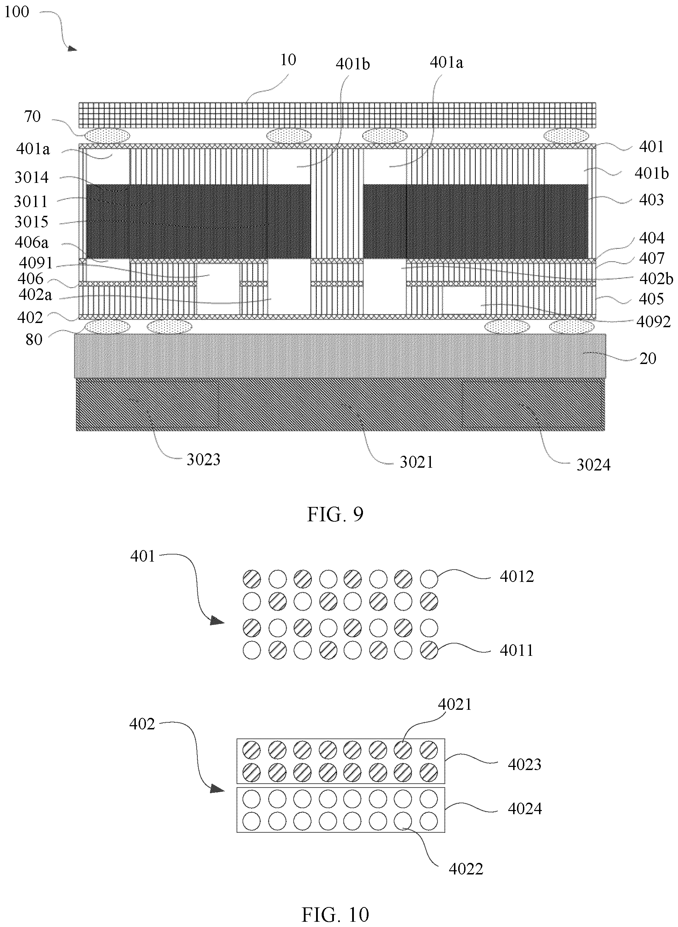

In some other embodiments, as shown in FIG. 9, the first filtering assembly 301 may include the first power terminal 3014 and the first ground terminal 3015. The first power terminal 3014 is electrically connected to the first conductive layer 401 through the first power supply conductive via 401a, and the first ground terminal 3015 is electrically connected to the first conductive layer 401 through the first ground conductive via 401b. A part of the first power terminal 3014 is electrically connected to the second conductive layer 402 through the second power supply conductive via 402a. A remaining part of the first power terminal 3014 is electrically connected to the fourth conductive layer 406 through a third power supply conductive via 406a. The fourth conductive layer 406 is electrically connected to the second conductive layer 402 through the second conductive connection via 4092. A part of the first ground terminal 3015 is electrically connected to the second conductive layer 402 through the second ground conductive via 402b. A remaining part of the first ground terminal 3015 is in contact with the third conductive layer 404. The third conductive layer 404 is electrically connected to the second conductive layer 402 through the first conductive connection via 4091. The third conductive layer 404 is the ground layer, and the fourth conductive layer 406 is the power supply layer. In this way, smoothness of a filtering path and a power supply path can be ensured.

It should be noted that in this embodiment of this application, a connection relationship between the first filtering assembly 301 and the conductive layer includes but is not limited to the following two possible implementations:

In a possible implementation, the first power terminal 3014 of the first filtering assembly 301 located in the projection region of the first region 4023 is electrically connected to the second conductive layer 402 through the third power supply conductive via 406a. The first ground terminal 3015 of the first filtering assembly 301 located in the projection region of the first region 4023 is in contact with the third conductive layer 404. The third conductive layer 404 is electrically connected to the second conductive layer 402 through the first conductive connection via 4091. The first power terminal 3014 of the first filtering assembly 301 located in the projection region of the second region 4024 is electrically connected to the fourth conductive layer 406 through the third power supply conductive via 406a. The fourth conductive layer 406 is electrically connected to the second conductive layer 402 through the second conductive connection via 4092. The first ground terminal 3015 of the first filtering assembly 301 located in the projection region of the second region 4024 is electrically connected to the second conductive layer 402 through the second ground conductive via 402b.

In this way, it can be ensured that the first power terminal 3014 of the first filtering assembly 301 located in the projection region of the first region 4023 is connected to the second power supply contact 4021 in the first region 4023, and the first ground terminal 3015 of the first filtering assembly 301 located in the projection region of the second region 4024 is connected to the second ground contact 4022 in the first region 4023.

In another possible implementation, the first power terminal 3014 of the first filtering assembly 301 located in the projection region of the first region 4023 is electrically connected to the fourth conductive layer 406 through the third power supply conductive via 406a. The fourth conductive layer 406 is electrically connected to the second conductive layer 402 through the second conductive connection via 4092. The first ground terminal 3015 of the first filtering assembly 301 located in the projection region of the first region 4023 is electrically connected to the second conductive layer 402 through the second ground conductive via 402b. The first power terminal 3014 of the first filtering assembly 301 located in the projection region of the second region 4024 is electrically connected to the second conductive layer 402 through the third power supply conductive via 406a. The first ground terminal 3015 of the first filtering assembly 301 located in the projection region of the second region 4024 is in contact with the third conductive layer 404. The third conductive layer 404 is electrically connected to the second conductive layer 402 through the first conductive connection via 4091.

In this way, it can be ensured that the first ground terminal 3015 of the first filtering assembly 301 located in the projection region of the first region 4023 is connected to the second ground contact 4022 in the first region 4023, and the first power terminal 3014 of the first filtering assembly 301 located in the projection region of the second region 4024 is connected to the second power supply contact 4021 in the first region 4023.

Similarly, in this way, an effect of current conduction between the first filtering assembly 301 and the fourth conductive layer 406 is enhanced. This enhances an effect of current conduction and filtering performance between the first filtering assembly 301 and the circuit board 20.

It may be understood that, in this embodiment of this application, as shown in FIG. 10, a quantity of second power supply contacts 4021 disposed may be greater than or equal to a quantity of first power supply contacts 4011 disposed, and a quantity of second ground contacts 4022 disposed is greater than or equal to a quantity of first ground contacts 4012 disposed.

In addition, a quantity of layers in the intermediate assembly 40 provided in this embodiment of this application may be two layers, three layers, four layers, or more layers for a circuit board, which is not limited in this embodiment of this application. In addition, a conductive via may be disposed between any two conductive layers to increase a through-current capability, and arrangement and a specific quantity of second power supply contacts 4021 may be flexibly set for interconnection between any layers.

It may be understood that, in this embodiment of this application, the intermediate assembly 40 may further include at least one fifth conductive layer (which not shown in the figure). The fifth conductive layer is located between the first conductive layer 401 and the first dielectric layer 403. In addition, a fourth dielectric layer or the like may be further disposed between the fifth conductive layer and the first conductive layer 401. This is not limited in this embodiment of this application, and this embodiment is not limited to the foregoing examples.

In this embodiment of this application, other technical features are the same as those in Embodiment 1, and can achieve same or corresponding technical effects. Details are not described herein again.

It should be noted that Embodiment 1 and Embodiment 2 may be separately used, or may be combined for use or used with reference to each other. This is not limited in this application.

### Embodiment 3

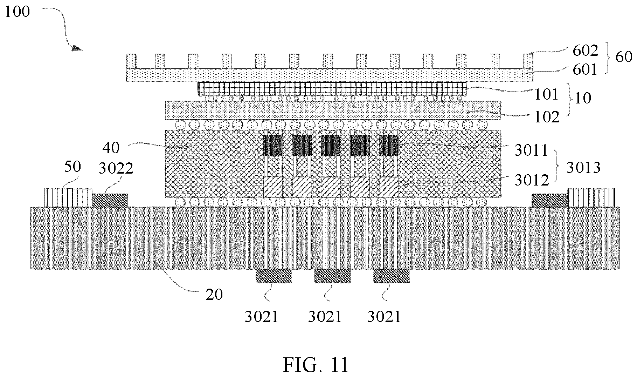

Different from Embodiment 1 and Embodiment 2, with reference to FIG. 11, in this embodiment of this application, a first filtering assembly 301 may include a plurality of first filtering components 3011 and a plurality of second filtering components 3012. In addition, along a thickness direction of a circuit board 20, the plurality of first filtering components 3011 and the plurality of second filtering components 3012 form a plurality of isolators 3013 in a one-to-one correspondence. The plurality of isolators 3013 are evenly spaced in an intermediate assembly 40. The plurality of first filtering components 3011 and the plurality of second filtering components 3012 form the plurality of isolators 3013 in a one-to-one correspondence, which can save a layout area of the circuit board 20, and further reduce transfer impedance between different power supply domains of a chip 10, so that noise is reduced and isolation of a filtering structure 100 is improved.

In this embodiment of this application, the first filtering component 3011 is located on a side that is of the intermediate assembly 40 and that is close to the chip 10, and the second filtering component 3012 is located on a side that is of the intermediate assembly 40 and that is close to the circuit board 20. The first filtering component 3011 is disposed on the side that is of the intermediate assembly 40 and that is close to the chip 10, and the second filtering component 3012 is disposed on the side that is of the intermediate assembly 40 and that is close to the circuit board 20. This can ensure that the first filtering component 3011 is close to the chip 10, so that a distance between the first filtering component 3011 and the chip 10 is small, and it is ensured that a filtering path of the chip 10 can be shortened.

In this embodiment of this application, the first filtering component 3011 may be a capacitor, and the second filtering component 3012 may be an inductor or a bead. An inductor, also referred to as an inductor coil, is an electromagnetic induction component formed by winding an insulation wire (such as an enameled wire or a cotton-covered wire). An inductor is a group of coaxial turns that are connected in series and made by using an enameled wire, a cotton-covered wire, or a plastic wire on an insulation frame or a magnetic core or an iron core. The inductor is mainly used to isolate and filter an alternating current signal, or form a resonant circuit with a capacitor or a resistor.

A bead is a component used to suppress high-frequency noise and peak interference on a signal line and a power wire, and further has a capability of absorbing an electrostatic pulse. The bead can be used to absorb an ultra-high-frequency signal. Beads need to be added to power input parts of some radio frequency (Radio frequency, RF) circuits, PLLs, oscillation circuits, and circuits including ultra-high-frequency memory.

It should be noted that, the inductor is an energy storage component, and is used in a resonant circuit, a low- and medium-frequency filter circuit, or the like. An application frequency range of the inductor rarely exceeds 50 MHz. The bead has high resistivity and magnetic permeability, which is equivalent to serial connection of resistor and inductor, except that values of resistance and inductance vary with the frequency.

In this embodiment of this application, other technical features are the same as those in Embodiment 1 or those in Embodiment 2, and can achieve same or corresponding technical effects. Details are not described herein again.

It should be noted that Embodiment 1, Embodiment 2, and Embodiment 3 may be separately used, or may be combined for use or used with reference to each other. This is not limited in this application.

### Embodiment 4

Based on Embodiment 1, Embodiment 2, and Embodiment 3, an embodiment of this application provides an electronic device. The electronic device may include a subrack (not shown) and the filtering structure 100 in any one of the foregoing embodiments. The filtering structure 100 is disposed in the subrack.

The electronic device provided in this embodiment of this application may include a filtering structure 100. In the filtering structure 100, an intermediate assembly 40 is disposed between a chip 10 and a circuit board 20, a first filtering assembly 301 is disposed inside the intermediate assembly 40, and at least a part of a second filtering assembly 302 is disposed on a surface that is of the circuit board 20 and that is away from the intermediate assembly 40. In a conventional technology, a low-frequency capacitor with a large capacity is disposed on the periphery of a chip and a high-frequency capacitor with a small capacity is disposed on a side that is of a circuit board and that is away from the chip. Compared to the conventional technology, in this embodiment, a distance between the first filtering assembly and the chip can be reduced. This shortens a filtering path of the chip, improves a dynamic response capability of the chip 10, and therefore improves an overall filtering capability of the electronic device.

In this embodiment of this application, other technical features are the same as those in Embodiment 1 or those in Embodiment 2, and can achieve same or corresponding technical effects. Details are not described herein again.

In descriptions of embodiments of this application, it should be noted that, unless otherwise clearly specified and limited, the terms "installation", "connection to", and "connection" should be understood in a broad sense. For example, the connection may be a fixed connection, may be an indirect connection by using an intermediate medium, or may be an internal connection between two elements or an interaction relationship between two elements. For persons of ordinary skill in the art, specific meanings of the foregoing terms in embodiments of this application may be understood based on a specific situation.

An apparatus or element in embodiments of this application or an implied apparatus or element needs to have a specific direction and be constructed and operated in a specific direction, and therefore cannot be construed as a limitation to embodiments of this application. In the descriptions of embodiments of this application, "plurality of" means two or more, unless otherwise precisely and specifically specified.

In the specification, claims, and accompanying drawings of embodiments of this application, the terms "first", "second", "third", "fourth", and so on (if existent) are intended to distinguish between similar objects but do not necessarily indicate a specific order or sequence. It should be understood that the data termed in such a way is interchangeable in proper circumstances so that embodiments of this application described herein can be implemented in an order other than the order illustrated or described herein. Moreover, the terms "may include", "contain" and any variant thereof are intended to cover a non-exclusive inclusion. For example, a process, method, system, product, or device that includes a list of steps or units is not necessarily limited to those steps or units that are expressly listed, but may include other steps or units not expressly listed or are inherent to the process, method, product, or device.

Finally, it should be noted that the foregoing embodiments are merely intended for describing the technical solutions in embodiments of this application, but not for limiting the technical solutions. Although embodiments of this application are described in detail with reference to the foregoing embodiments, persons of ordinary skill in the art should understand that they may still make modifications to the technical solutions described in the foregoing embodiments or make equivalent replacements to some or all of the technical features thereof. These modifications or replacements do not make the essence of the corresponding technical solutions depart from the scope of the technical solutions in embodiments of this application.

## Claims

1. A filtering structure, comprising:
a chip, a circuit board, a filtering assembly, and an intermediate assembly located between the chip and the circuit board, wherein
the filtering assembly comprises a first filtering assembly and a second filtering assembly, the first filtering assembly is located in the intermediate assembly, and at least a part of the second filtering assembly is located on a surface that is of the circuit board and that is away from the intermediate assembly.

2. The filtering structure according to claim 1, wherein the first filtering assembly comprises a plurality of first filtering components, and the plurality of first filtering components are evenly spaced in the intermediate assembly.

3. The filtering structure according to claim 2, wherein the first filtering component is a capacitor.

4. The filtering structure according to claim 1, wherein the first filtering assembly comprises a plurality of first filtering components and a plurality of second filtering components; and along a thickness direction of the circuit board, the plurality of first filtering components and the plurality of second filtering components form a plurality of isolators in a one-to-one correspondence; and
the plurality of isolators are evenly spaced in the intermediate assembly.

5. The filtering structure according to claim 4, wherein the first filtering component is located on a side that is of the intermediate assembly and that is close to the chip, and the second filtering component is located on a side that is of the intermediate assembly and that is close to the circuit board.

6. The filtering structure according to claim 4 or 5, wherein the first filtering component is a capacitor, and the second filtering component is an inductor or a bead.

7. The filtering structure according to any one of claims 1 to 6, wherein the second filtering assembly comprises at least one third filtering component, and the at least one third filtering component is located on a surface that is of the circuit board and that is away from the intermediate assembly.

8. The filtering structure according to claim 7, wherein the third filtering component is a capacitor.

9. The filtering structure according to claim 7 or 8, wherein a projection area of the first filtering component along the thickness direction of the circuit board is less than a projection area of the third filtering component along the thickness direction of the circuit board.

10. The filtering structure according to any one of claims 1 to 9, wherein the intermediate assembly comprises at least two conductive layers disposed in a laminated manner, and a dielectric layer is disposed between two adjacent conductive layers; and
the first filtering assembly is located in the dielectric layer, and both ends of the first filtering assembly are electrically connected to the conductive layers located on two sides of the dielectric layer.

11. The filtering structure according to claim 10, wherein the at least two conductive layers comprise a first conductive layer and a second conductive layer, a first dielectric layer is disposed between the first conductive layer and the second conductive layer, and the first filtering assembly is located in the first dielectric layer; and
one of the first conductive layer and the second conductive layer is electrically connected to the chip, and the other of the first conductive layer and the second conductive layer is electrically connected to the circuit board.

12. The filtering structure according to claim 11, wherein the first conductive layer has a plurality of first power supply contacts and a plurality of first ground contacts, and the plurality of first power supply contacts and the plurality of first ground contacts are alternately spaced;
the second conductive layer has a plurality of second power supply contacts and a plurality of second ground contacts, the second conductive layer is divided into a first region and a second region, the plurality of second power supply contacts are located in either the first region or the second region, and the plurality of second ground contacts are located in either the first region or the second region;
the first power supply contacts are electrically connected to the second power supply contacts, and the first ground contacts are electrically connected to the second ground contacts; and
the first conductive layer is electrically connected to one of the chip and the circuit board through the plurality of first power supply contacts and the plurality of first ground contacts, and the second conductive layer is electrically connected to the other of the chip and the circuit board through the plurality of second power supply contacts and the plurality of second ground contacts.

13. The filtering structure according to claim 12, wherein the first filtering assembly comprises a first power terminal and a first ground terminal;
a part of the first power terminal is electrically connected to both the first conductive layer and the second conductive layer, and a remaining part of the first power terminal is electrically connected to only the first conductive layer; and
a part of the first ground terminal is electrically connected to only the first conductive layer, and a remaining part of the first ground terminal is electrically connected to both the first conductive layer and the second conductive layer.

14. The filtering structure according to claim 13, wherein the first power terminal located in a projection region of the first region is electrically connected to both the first conductive layer and the second conductive layer, and the first ground terminal located in the projection region of the first region is electrically connected to only the first conductive layer; and
the first power terminal located in a projection region of the second region is electrically connected only to the first conductive layer, and the first ground terminal located in the projection region of the second region is electrically connected to both the first conductive layer and the second conductive layer; or
the first power terminal located in a projection region of the first region is electrically connected only to the first conductive layer, and the first ground terminal located in the projection region of the first region is electrically connected to both the first conductive layer and the second conductive layer; and
the first power terminal located in a projection region of the second region is electrically connected to both the first conductive layer and the second conductive layer, and the first ground terminal located in the projection region of the second region is electrically connected to only the first conductive layer.

15. The filtering structure according to claim 12, wherein the at least two conductive layers further comprise a third conductive layer and a fourth conductive layer;
the third conductive layer and the fourth conductive layer are both located between the first dielectric layer and the second conductive layer, and a second dielectric layer is disposed between the third conductive layer and the fourth conductive layer; and
the third conductive layer is located between the first dielectric layer and the second dielectric layer, and a third dielectric layer is further disposed between the fourth conductive layer and the second conductive layer, wherein
one of the third conductive layer and the fourth conductive layer is a power supply layer, and the other of the third conductive layer and the fourth conductive layer is a ground layer.

16. The filtering structure according to claim 15, wherein the first filtering assembly comprises a first power terminal and a first ground terminal;
the first power terminal is electrically connected to the first conductive layer through a first power supply conductive via, and the first ground terminal is electrically connected to the first conductive layer through a first ground conductive via;
a part of the first power terminal is electrically connected to the second conductive layer through a second power supply conductive via, a remaining part of the first power terminal is in contact with the third conductive layer, and the third conductive layer is electrically connected to the second conductive layer through a first conductive connection via; and
a part of the first ground terminal is electrically connected to the second conductive layer through a second ground conductive via, a remaining part of the first ground terminal is electrically connected to the fourth conductive layer through a third ground conductive via, and the fourth conductive layer is electrically connected to the second conductive layer through a second conductive connection via, wherein
the third conductive layer is the power supply layer, and the fourth conductive layer is the ground layer.

17. The filtering structure according to claim 16, wherein the first power terminal located in a projection region of the first region is electrically connected to the second conductive layer through the second power supply conductive via, the first ground terminal located in the projection region of the first region is electrically connected to the fourth conductive layer through the third ground conductive via, and the fourth conductive layer is electrically connected to the second conductive layer through the second conductive connection via; and
the first power terminal located in a projection region of the second region is in contact with the third conductive layer, the third conductive layer is electrically connected to the second conductive layer through the first conductive connection via, and the first ground terminal located in the projection region of the second region is electrically connected to the second conductive layer through the second ground conductive via; or
the first power terminal located in a projection region of the first region is in contact with the third conductive layer, the third conductive layer is electrically connected to the second conductive layer through the first conductive connection via, and the first ground terminal located in the projection region of the first region is electrically connected to the second conductive layer through the second ground conductive via; and
the first power terminal located in a projection region of the second region is electrically connected to the second conductive layer through the second power supply conductive via, the first ground terminal located in the projection region of the second region is electrically connected to the fourth conductive layer through the third ground conductive via, and the fourth conductive layer is electrically connected to the second conductive layer through the second conductive connection via.

18. The filtering structure according to claim 15, wherein the first filtering assembly comprises a first power terminal and a first ground terminal;
the first power terminal is electrically connected to the first conductive layer through a first power supply conductive via, and the first ground terminal is electrically connected to the first conductive layer through a first ground conductive via;
a part of the first power terminal is electrically connected to the second conductive layer through a second power supply conductive via, a remaining part of the first power terminal is electrically connected to the fourth conductive layer through a third power supply conductive via, and the fourth conductive layer is electrically connected to the second conductive layer through a second conductive connection via; and
a part of the first ground terminal is electrically connected to the second conductive layer through a second ground conductive via, a remaining part of the first ground terminal is in contact with the third conductive layer, and the third conductive layer is electrically connected to the second conductive layer through a first conductive connection via, wherein
the third conductive layer is the ground layer, and the fourth conductive layer is the power layer.

19. The filtering structure according to claim 18, wherein the first power terminal located in a projection region of the first region is electrically connected to the second conductive layer through the third power supply conductive via, the first ground terminal located in the projection region of the first region is in contact with the third conductive layer, and the third conductive layer is electrically connected to the second conductive layer through the first conductive connection via; and
the first power terminal located in a projection region of the second region is electrically connected to the fourth conductive layer through the third power supply conductive via, the fourth conductive layer is electrically connected to the second conductive layer through the second conductive connection via, and the first ground terminal located in the projection region of the second region is electrically connected to the second conductive layer through the second ground conductive via; or
the first power terminal located in a projection region of the first region is electrically connected to the fourth conductive layer through the third power supply conductive via, the fourth conductive layer is electrically connected to the second conductive layer through the second conductive connection via, and the first ground terminal located in the projection region of the first region is electrically connected to the second conductive layer through the second ground conductive via; or
the first power terminal located in a projection region of the second region is electrically connected to the second conductive layer through the third power supply conductive via, the first ground terminal located in the projection region of the second region is in contact with the third conductive layer, and the third conductive layer is electrically connected to the second conductive layer through the first conductive connection via.

20. An electronic device, comprising a subrack and the filtering structure according to any one of claims 1 to 19, wherein the filtering structure is disposed in the subrack.
